# EUROPÄISCHE PATENTSCHRIFT

(11) **EP 1 091 389 B1**
(45) Veröffentlichungstag und Bekanntmachung des Hinweises auf die Patenterteilung: **14.02.2007**
(21) Anmeldenummer: 00121848.6
(22) Anmeldetag: 06.10.2000
(51) Int. Cl.: H01L 21/00, B66C 1/00, B25B 11/00, B65G 47/00

(54) **Bernoulli- und Vakuum-Kombigreifer**
Bernoulli and vacuum combined gripper
Dispositif préhenseur combiné de type Bernoulli et à dépression

(30) Priorität: 08.10.1999 DE 19948572
(43) Veröffentlichungstag der Anmeldung: 11.04.2001
(73) Patentinhaber: Infineon Technologies AG, 81669 München (DE)
(72) Erfinder: Matschitsch, Martin, 9181 Feistritz i. Ros (AT); Pucher, Gerhard, 9500 Villach (AT); Unterweger, Josef, 9520 Annenheim (AT); Zerlauth, Stefan, 9020 Klagenfurt (AT); Scherf, Werner, 8130 Frohnleiten (AT); Rudolph, Conny-Norbert, 9500 Villach (AT); Ladinig, Marcello, 9170 Ferlach (AT); Kroupa, Gerhard, 9500 Villach (AT); Binder, Alfred, 9500 Landskron (AT); Giovannini, Alberto, 9500 Villach (AT); Aigner, Kurt, 9073 Viktring (AT); Manzoni, Giulio, 9500 Villach (AT)
(74) Vertreter: Müller - Hoffmann & Partner

(56) Entgegenhaltungen:
- US-A- 4 566 726
- US-A- 5 169 196
- PATENT ABSTRACTS OF JAPAN Bd. 1998, Nr. 06, 30. April 1998 (1998-04-30) -& JP 10 041376 A (NIKON CORP), 13. Februar 1998 (1998-02-13)
- PATENT ABSTRACTS OF JAPAN Bd. 008, Nr. 139 (E-253), 28. Juni 1984 (1984-06-28) -& JP 59 048938 A (TOKYO SHIBAURA DENKI KK), 21. März 1984 (1984-03-21)
- PATENT ABSTRACTS OF JAPAN Bd. 015, Nr. 291 (E-1093), 24. Juli 1991 (1991-07-24) -& JP 03 102850 A (FUJITSU LTD), 30. April 1991 (1991-04-30)

## Beschreibung

Die Erfindung gemäß dem Anspruch 1 betrifft einen Greifer, mit dem scheibenförmige Gegenstände, insbesondere Halbleiterscheiben bzw. Wafer, wie sie in der Halbleitertechnik verwendet werden, gehandhabt werden können.

Das Handhaben von scheibenförmigen Gegenständen bzw. Wafern stellt, insbesondere wenn es sich um dünne, verbogene Wafer handelt, erhebliche Probleme dar.

Bekannte Greifer für Wafer basieren auf mechanischen Klemmvorrichtungen, die am Rand des Wafers angreifen. Andere Greifer halten den Wafer durch Anlegen von Unterdruck.

Da heutzutage Wafer immer dünner werden bei Wafergrößen bzw. -durchmessern von 12,7 cm; 15,24 cm und 20,32 cm (5, 6 und 8 Zoll) eine Dicke bis zu 50 µm haben, sind herkömmliche Greifer nicht mehr ohne weiteres verwendbar. Dünne Wafer brechen nicht nur leicht, sondern zeigen auch Verbiegungen (bis zu 16 mm aus der Ebene des Wafers) und damit auch starke Verspannungen. Um solche Wafer sicher handhaben zu können, beispielsweise beim Be- und Entladen von Horden, Quarzbooten und dergleichen, ist es erforderlich, den Wafer auf dem Greifer eben zu stabilisieren.

Wafer sind bekanntlich also sehr dünn und weisen bei einem Durchmesser in der Größenordnung von dm Scheibendicken auf, die in der Größenordnung von einigen 10 bis einigen 100 µm liegen. Solche Halbleiterscheiben werden bisher zumeist manuell bzw. mit einem Handlingsystem von einem ersten Prozessierungsort zu einem zweiten Prozessierungsort gebracht. Beispielsweise werden nach einem Dünnschleifen oft verbogene Halbleiterscheiben erhalten, die sowohl konkave als auch konvexe Krümmungen enthalten können. Diese Halbleiterscheiben können durch das Handlingsystem nicht mehr problemfrei ge-handhabt werden. Daher werden sie oft mithilfe einer Pinzette aus einem entsprechenden Behälter entnommen und zur weiteren Prozessierung beispielsweise in ein Quarzboot gebracht. Der Einsatz einer Pinzette ist aber nicht unproblematisch, da dieser zu teilweisen Beschädigungen wie der Entstehung von Haarrissen und damit zu einem Ausfall von Chips in dem entsprechenden Bereich der Halbleiterscheibe führen kann.

Aufgrund der obigen Überlegungen wurde bereits daran gedacht, für das Handhaben von scheibenförmigen Gegenständen, insbesondere Wafern, einen Greifer zur Verfügung zu stellen, mit dem diese erfasst und gehalten werden können, indem Saugdruck und Unterdruck zur Anwendung gebracht werden.

Die US-A-4,566,726 beschreibt eine Handhabungsvorrichtung für Halbleiterwafer, bei der sowohl ein Bernoulli-Saugdruck als auch ein Unterdruck zur Anwendung gelangen. Dort gelangt die gleiche Verrohrung für Saugdruck und Unterdruck zur Anwendung. Auf diese Weise können Saugdruck und Unterdruck nur nacheinander, und nicht gleichzeitig und separat voneinander eingestellt werden.

Als weiteres Beispiel für einen Greifer für Wafer, bei dem die Wirkungsmechanisamen zum Festhalten des Wafers Saugdruck und Unterdruck nicht gleichzeitig und separat eingestellt werden können, ist auf die US-A-5,169,196 zu verweisen.

Der Erfindung liegt die Aufgabe zu Grunde, einen Greifer für das Handhaben von scheibenförmigen Gegenständen, insbesondere Wafern, zur Verfügung zu stellen, mit dem auch Wafer mit größerem Durchmesser, selbst wenn diese dünn und/oder gebogen sind, sicher erfasst, gehalten und gehandhabt werden können.

Diese Aufgabe wird erfindungsgemäß mit einem Greifer gelöst, der die Merkmale des unabhängigen Anspruches 1 aufweist.

Bevorzugte und vorteilhafte Ausgestaltungen des erfindungsgemäßen Greifers sind Gegenstand der Unteransprüche.

Bei dem erfindungsgemäßen Greifer wird zum einen das an sich bekannte Prinzip des Haltens eines Wafers durch Unterdruck, der den Wafer an den Greifer saugt, angewendet.

Ein Nachteil des Haltens von Wafern an einen Greifer nur durch Unterdruck besteht darin, dass allein durch Anlegen von Unterdruck stark verbogene Wafer nicht planarisiert und an den Greifer angelegt werden können. Ein weiteres Problem besteht darin, dass bei groß dimensionierten Öffnungen im Greifer, die mit Unterdruck beaufschlagt werden, bei sehr dünnen Wafern in den Wafern Strukturschäden entstehen können.

Durch die bei dem erfindungsgemäßen Greifer zusätzlich zu dem Anlegen von Unterdruck auf den Wafer einwirkende, auf Grund des Bernoulli-Prinzips beim Ausströmen von Gas wie Luft oder Stickstoff, aus (wenigstens) einer Düse im Greifer erzeugte Kraft wird der Wafer zu der dem Wafer zugekehrten Fläche des Greifers hin gezogen und planarisiert. Ein Vorteil des Bernoulli-Prinzips ist es, das die durch dieses erzeugte Kraft auch stark verbogene Wafer anzieht und eben macht (planarisiert). Nachteilig ist hingegen, dass der Wafer auf der Oberfläche des Greifers schwimmt, sodass zusätzliche Vorrichtungen zum seitlichen Fixieren des Wafers nötig sind, wenn ein Greifer ausschließlich nach dem Bernoulli-Prinzip arbeitet.

Bei dem erfindungsgemäßen Greifer wird die durch das Bernoulli-Prinzip erzeugte Kraft zum Planarisieren des Wafers und zum Anlegen desselben an den Greifer angewendet und das Anlegen von Unterdruck dazu benutzt, den Wafer zu stabilisieren und auf dem Greifer zu halten. Somit wird bei dem erfindungsgemäßen Greifer zum Erfassen eines Wafers das Bernoulli-Prinzip und Unterdruck gleichzeitig aktiviert. Beim anschließenden Halten des Wafers am Greifer kann das Ausströmen von Gas und damit das Halten nach dem Bernoulli-Prinzip abgebrochen werden, und der Wafer wird dann lediglich durch Anlegen von Unterdruck an die im Greifer vorgesehenen Vakuum- bzw. Unterdruckköpfe am Wafer gehalten.

Die erfindungsgemäße Konstruktion des Greifers erlaubt es in einer Ausführungsform diesen sehr flach auszubilden.

Dabei kann in einer Ausführungsform die für das Bernoulli-Prinzip notwendige Strömung von Gas so tangential auf die Greiferoberfläche umgeleitet und geführt werden, dass die Haltekraft durch das Anlegen von Unterdruck nicht beinflusst wird.

In einer Ausführungsform des erfindungsgemäßen Greifers sind quer zur Ebene des Greifers beweglich angeordnete Vakuumköpfe vorgesehen, sodass auch stark verbogene bzw. verspannte Wafer durch Unterdruck gehalten werden können. Die Erfindung erlaubt es, die Vakuumköpfe beispielsweise durch nur kleine Kanäle an der Oberfläche derselben so anzulegen, dass auch bei sehr dünnen Wafern auf Grund des Unterdruckes keine Strukturschäden entstehen.

Bevorzugt ist es, wenn bei dem erfindungsgemäßen Greifer die Leitungen, mit welchen die Vakuumköpfe mit Unterdruck und die Düsen für den Austritt von Gas zum Halten nach dem Bernoulli-Prinzip mit unter Druck stehendem Gas beaufschlagt werden, im Greifer geführte Leitungen sind.

In der Praxis kann bei der Erfindung vorgesehen sein, dass durch einen Kanal im Greifer und in der Haltestange für diesen Gas, wie Luft oder Stickstoff, für das Halten nach dem Bernoulli-Prinzip mit mehrfachem Atmosphärendruck auf der Greiferoberfläche durch wenigstens eine Düse austritt. Bevorzugt ist es, wenn das Gas in einem Kanal, der mehrere kreissegmentförmige Öffnungen hat, geführt wird, wobei die Ausströmöffnungen tangential oder im spitzen Winkel zur Greiferoberfläche ausgebildet sein können.

Die bei dem erfindungsgemäßen Greifer in einer Ausführungsform vorgesehenen Vakuumköpfe selbst sind bevorzugt aus hartem Werkstoff gefertigt, sodass sichergestellt ist, dass kein Abrieb auf dem Wafer erfolgt. Bevorzugt ist es, wenn die Vakuumköpfe im Greifer quer zur Ebene des Greifers federelastisch beweglich gelagert sind, was beispielsweise dadurch erreicht werden kann, dass die Lagerung und die Zuführung von Unterdruck zu den Vakuumköpfen aus flexiblem Werkstoff, beispielsweise gummielastischem Werkstoff, angefertigt sind.

Der erfindungsgemäße Greifer nutzt sowohl das Bernoulli-Prinzip zum Erzeugen einer den Wafer zum Greifer hin ziehenden Kraft als auch ein Ansaugen durch wenigstens eine Saugbohrung (Vakuumkopf), die sich in der dem Wafer zugekehrten Fläche des Greifers befindet, aus, um den Wafer praktisch berührungsfrei am Greifer haften zu lassen, sodass er sicher und zuverlässig gehandhabt werden kann. Zerstörungen oder Beschädigungen (Strukturschäden) des Wafers sind nicht zu befürchten, da er von der ihm zugekehrten Fläche des Greifers durch eine dünne Gasströmung getrennt ist. So kann ein Wafer zerstörungs- und beschädigungsfrei manuell oder auch automatisch transportiert und gehandhabt werden.

Weiterhin erfolgt durch die auf Grund des Bernoulli-Prinzips entstehende Kraft, welche den Wafer gegen den Greifer drückt, ein Einebnen des Wafers, sodass dieser keine konkaven oder konvexen Krümmungen mehr aufweist, solange er mit dem erfindungsgemäßen Greifer transportiert oder gehalten wird.

Das Erzeugen einer Kraft auf Grund des Bernoulli-Prinzips durch ein aus den Düsen strömendes Gas einerseits und das Erzeugen eines Saugdruckes durch Ansaugen von Luft durch den wenigstens einen Vakuumkopf andererseits sind vorzugsweise getrennt steuerbar. Es ist also möglich, den erfindungsgemä-ßen Greifer zeitweise nur über die durch das strömende Druckgas entstehende Kraft und zeitweise nur über den durch den Vakuumkopf erzeugten Saugdruck zu betreiben. Dies schließt freilich einen gleichzeitigen Betrieb des Greifers mit Druckgas (Bernoulli-Kraft) und mit Unterdruck (Ansaugen durch wenigstens einen Vakuumkopf) nicht aus.

Der erfindungsgemäße Greifer nutzt also sowohl das Bernoulli-Prinzip zur Erzeugung eines hydrodynamischen Unterdrucks zwischen Düsenplatte und Halbleiterscheibe als auch ein gleichzeitiges Ansaugen durch eine Saugbohrung, die sich vorzugsweise in der Mitte der Düsenplatte befindet, aus, um die Halbleiterscheibe praktisch berührungsfrei an der Düsenplatte "haften" zu lassen, sodass sie sicher und zuverlässig transportiert und gehandhabt werden kann. Zerstörungen oder Beschädigungen der Halbleiterscheibe sind nicht zu befürchten, da diese von der Düsenplatte durch eine dünne Luftströmung getrennt ist. Damit kann die Halbleiterscheibe zerstörungs- und beschädigungsfrei manuell oder auch automatisch transportiert und gehandhabt werden.

Weiterhin erfolgt durch das Pressen der Halbleiterscheibe infolge des hydrodynamischen Unterdrucks gegen die Düsenplatte eine Einebnung der Halbleiterscheibe, sodass diese keine konkaven oder konvexen Krümmungen mehr aufweist, solange sie mit der erfindungsgemäßen Vorrichtung transportiert wird bzw. an der Düsenplatte angebracht ist.

Die Erzeugung des hydrodynamischen Unterdrucks zwischen der Düsenplatte durch die aus den Düsen der Düsenplatte strömende Luft einerseits und die Erzeugung des Saugdruckes durch Ansaugen von Luft durch die Saugbohrung andererseits sind vorzugsweise getrennt steuerbar. Es ist also möglich, den erfindungsgemäßen Greifer zeitweise nur über den durch die Düsenplatte gelieferten Unterdruck und zeitweise nur über den durch die Saugbohrung erzeugten Saugdruck zu betreiben.

Der Greifer kann extrem dünn mit einer Bauhöhe von nur etwa 2 bis 3 mm ausgebildet werden. Damit ist es möglich, mit der Düsenplatte zwischen zwei übereinander in einer Horde liegenden Halbleiterscheiben einzugreifen und eine dieser Halbleiterscheiben aufzunehmen.

In einer Weiterbildung der Erfindung ist vorgesehen, dass auch im Randbereich der Düsenplatte zusätzliche Saugbohrungen vorgesehen sind. Greifer, die derartige zusätzliche Saugbohrungen im Randbereich der Düsenplatte aufweisen, haben sich als besonders vorteilhaft zum Bestücken von Quarzbooten mit Halbleiterscheiben erwiesen.

Wesentlich an der vorliegenden Erfindung ist also die gemeinsame Verwendung einerseits des nach Bernoulli erzeugten hydrodynamischen Unterdrucks, der ein "Haften" zwischen Halbleiterscheibe und Düsenplatte bewirkt, und wenigstens einer Saugbohrung andererseits, die, wenn sie in der Mitte der Düsenplatte angeordnet ist, eine Zentrierung der Halbleiterscheibe auf diese Mitte gestattet.

Weitere Einzelheiten und Merkmale der Erfindung ergeben sich aus der nachstehenden Beschreibung bevorzugter Ausführungsbeispiele des erfindungsgemäßen Greifers anhand der Zeichnungen. Es zeigen:
- Fig. 1: in Schrägansicht schematisiert einen Greifer mit Austrittsöffnungen für Druckgas und mit Vakuumköpfen,
- Fig. 2: den Greifer mit auseinandergezogen dargestellten Bestandteilen,
- Fig. 3: ein Einzelteil des Greifers mit einem Vakuumkopf (längs dessen Symmetrieebene halbiert),
- Fig. 4: den Bauteil des Greifers, über den Unterdruck und Druckgas zugeführt wird,
- Fig. 5: den Bauteil aus Fig. 4 von unterhalb der Fig. 4 aus gesehen,
- Fig. 6: eine abgeänderte Ausführungsform eines Greifers gemäß der Erfindung,
- Fig. 7: eine abgeänderte Ausführungsform eines erfindungsgemäßen Greifers,
- Fig. 8: die Ausführungsform des Greifers von Fig. 7 in auseinandergezogener Darstellung,
- Fig. 9: einen quer zum Greifer beweglichen Vakuumkopf im Schnitt, ohne Beaufschlagung mit Unterdruck,
- Fig. 10: den Vakuumkopf aus Fig. 9, mit Unterdruck beaufschlagt,
- Fig. 11: eine andere Ausführungsform eines Vakuumkopfes des erfindungsgemäßen Greifers ohne Beaufschlagung mit Unterdruck,
- Fig. 12: den Vakuumkopf aus Fig. 11, mit Unterdruck beaufschlagt,
- Fig. 13: eine schematische Darstellung eines weiteren Ausführungsbeispiels mit einem Handling-Werkzeug für dünne Halbleiterscheiben ("Dünnwafer") und
- Fig. 14: eine schematische Darstellung eines Greifers für Dünnwafer.

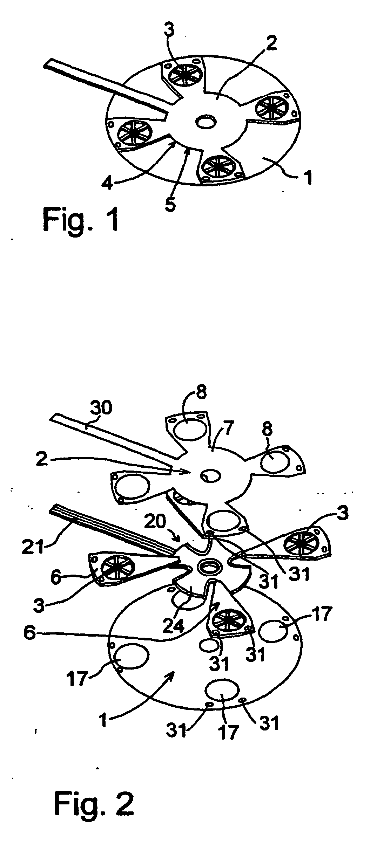

Ein in Fig. 1 beispielhaft gezeigter Greifer gemäß der Erfindung besteht aus einer kreisrunden Basisplatte 1, einer im gezeigten Ausführungsbeispiel etwa sternförmig ausgebildeten Deckplatte 2 und im gezeigten Ausführungsbeispiel vier Vakuumköpfen 3, wobei zwischen der Basisplatte 1 und der Deckplatte 2 im Bereich ihrer radial -innerhalb des Außenumfanges der Basisplatte 1 liegenden Randbereiche 4 Ausströmöffnungen 5 für Druckgas zum Erzeugen von Kräften auf Grund des Bernoulli-Prinzips vorgesehen sind.

Die Vakuumköpfe 3 sind in Halteteilen (vgl. Fig. 2) gehalten und von oben, also von der dem zu haltenden Wafer zugekehrten Seite des Greifers her durch in radial abstehenden Armen 7 der Deckplatte 2 vorgesehene, beispielsweise kreisrunde Öffnungen 8 zugänglich.

Die Halteteile 6 sind aus gummielastischem Werkstoff gefertigt, wogegen die Vakuumköpfe 3 selbst aus abriebfestem Werkstoff sind.

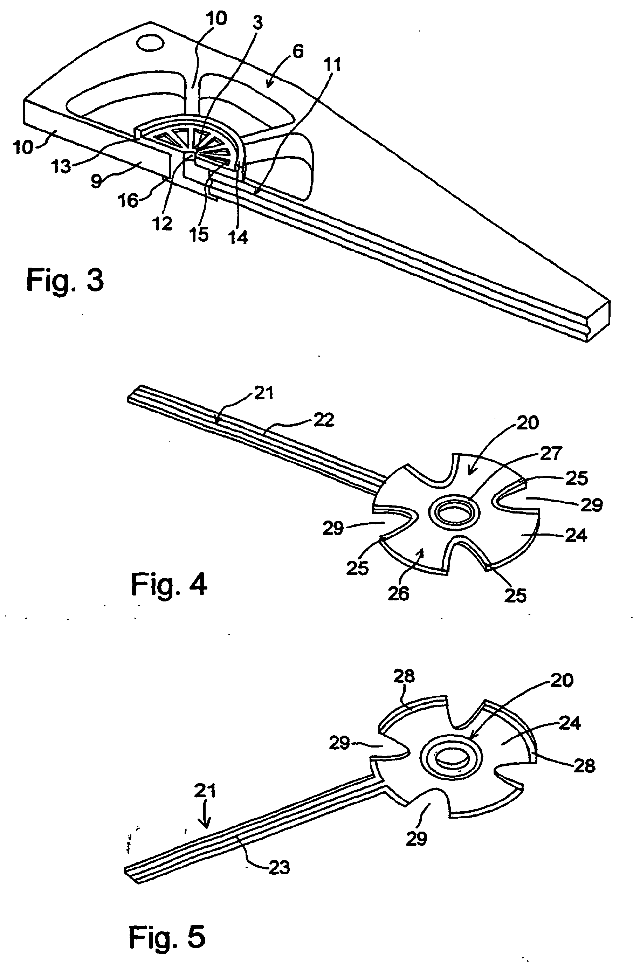

Wie insbesondere Fig. 3 zeigt, sind die Vakuumköpfe 3 in den Halteteilen 6 in einen Haltering 9 eingesetzt, wobei der Haltering 9 mit dem übrigen Teil des Halteteils 6 durch Speichen 10 verbunden ist. In einer mittigen Öffnung des Halterings 9 mündet ein Kanal 11, der an eine Unterdruckquelle angeschlossen ist, sodass die Vakuumköpfe 3 über ihre zentrale Öffnung 12 mit Unterdruck beaufschlagt werden können.

Ein tellerförmiger Oberteil 13 der Vakuumköpfe 3, das von oben her auf dem Halteteil 6 aufliegt, besitzt einen Umfangsrand 14 und kreissegmentförmige Vorsprünge 15, die rings um die zentrale Öffnung 12 des Vakuumkopfes 3 angeordnet sind. Durch den nach oben vorstehenden Rand 14 und die nach oben vorstehenden Vorsprünge 15 des Vakuumkopfes 3 wird ein Wafer am Vakuumkopf 3 gut abgestützt, sodass auch in sehr dünnen Wafern durch den angelegten Unterdruck keine Strukturschäden entstehen können.

Die Vakuumköpfe 3 können einfach durch Einclipsen in den Trageteil 6 montiert werden, und sie werden in diesem oben durch den Oberteil 13 und unten durch einen Ringflansch 16 gehalten.

Durch die beschriebene Ausbildung des Halteteils 6 und durch das Ausführen desselben aus gummielastischem Werkstoff sind die Vakuumköpfe 3 im Greifer elastisch federnd montiert, sodass sie sich senkrecht zur Ebene des Greifers bewegen können, zumal auch in der Basisplatte 1 mit den Öffnungen 8 korrespondierende Öffnungen 17 vorgesehen sind.

Zum Beaufschlagen des Greifers mit Unterdruck (für die Vakuumköpfe 3) einerseits und mit Druckgas (für die düsenartigen Austrittsöffnungen 5) andererseits ist ein als Druckgas-/Unterdruckzuführung in den Fig. 4 und 5 für sich dargestellter Bauteil 20 vorgesehen. Dabei zeigt Fig. 4 die Seite dieses Bauteils 20, die der Deckplatte 2 zugekehrt ist und über die Druckgas zugeführt wird. Fig. 5 zeigt die der Basisplatte 1 zugekehrte Seite des Bauteils 20, die mit Unterdruck beaufschlagt wird. Der Bauteil 20 besteht aus einem stabförmigen Teil 21, an dessen einer Seite ein Druckgaskanal 22 und an dessen anderer Seite ein Unterdruckkanal 23 ausgespart ist. Des Weiteren besitzt der Bauteil 20 einen scheibenförmigen Teil 24 mit zu seinem Rand hin offenen Ausschnitten 29. An der der Deckplatte 2 zugekehrten Seite des Teils 24 sind U-förmige Vorsprünge 25, die am Rand der Ausschnitte 29 liegen, vorgesehen. Zwischen den Enden benachbarter U-förmiger Vorsprünge 25 ergeben sich somit Vertiefungen 26, die zusammen mit der Deckplatte 2 die düsenartigen Ausströmöffnungen 5 für das Druckgas bilden.

In den Vertiefungen 26 des Bauteils 20 können Vorsprünge, die als rippen- und/oder zapfenartige Vorsprünge ausgebildet sein können, vorgesehen sein. Diese Vorsprünge (nicht gezeigt) dienen als Strömungswiderstände und gewährleisten einen gleichmäßigen Druckaufbau im Düsenbereich und somit ein gleichmäßiges Ausströmen des Druckgases aus den düsenartigen Ausströmöffnungen 5. Durch das aus den düsenartigen Ausströmöffnungen 5 ausströmende Druckgas wird nach dem Bernoulli-Prinzip zwischen einem auf den Greifer (von oben der Fig. 1 her) aufgelegten Wafer und dem Greifer selbst eine Kraft erzeugt, die den Wafer zum Greifer hin zieht.

Zur Mitte hin ist der Teil 24 des Bauteils 20 durch einen gestuften ringförmigen Vorsprung 27 zur Deckplatte 2 und einer in dieser vorgesehenen mittigen Öffnung hin abgedichtet.

Auf der der Basisplatte 1 zugekehrten Seite des Teils 20 sind am Rand des Teils 24 zwischen den Ausschnitten 29 bogenförmige Rippen 28, die nach unten hin vorstehen und die an der Basisplatte 1 anliegen, vorgesehen.

Wie Fig. 2 erkennen lässt, greifen die Halteteile 6 für die Vakuumköpfe 3 mit ihren radial innen liegenden Enden in die Aussparungen 29 des Teils 24 ein, sodass die Vakuumkanäle 11 in den Halteteilen 6 mit dem zwischen dem Teil 24 und der Basisplatte 1 liegenden Raum über den Kanal (23) mit Unterdruck beaufschlagt werden können.

Der Kanal 22 in dem stabförmigen Ansatz 21 des Teils 20 kann durch eine Verlängerung 30 der Deckplatte 2 geschlossen werden. Sinngemäßes gilt für den Kanal 23, der mit Unterdruck beaufschlagt wird.

Die Basisplatte 1, die Halteteile 6 und die Deckplatte 2 können durch Verbindungsmittel, welche durch Löcher 31 in den genannten Bauteilen gesteckt werden, miteinander zu dem Greifer gemäß Fig. 1 verbunden werden.

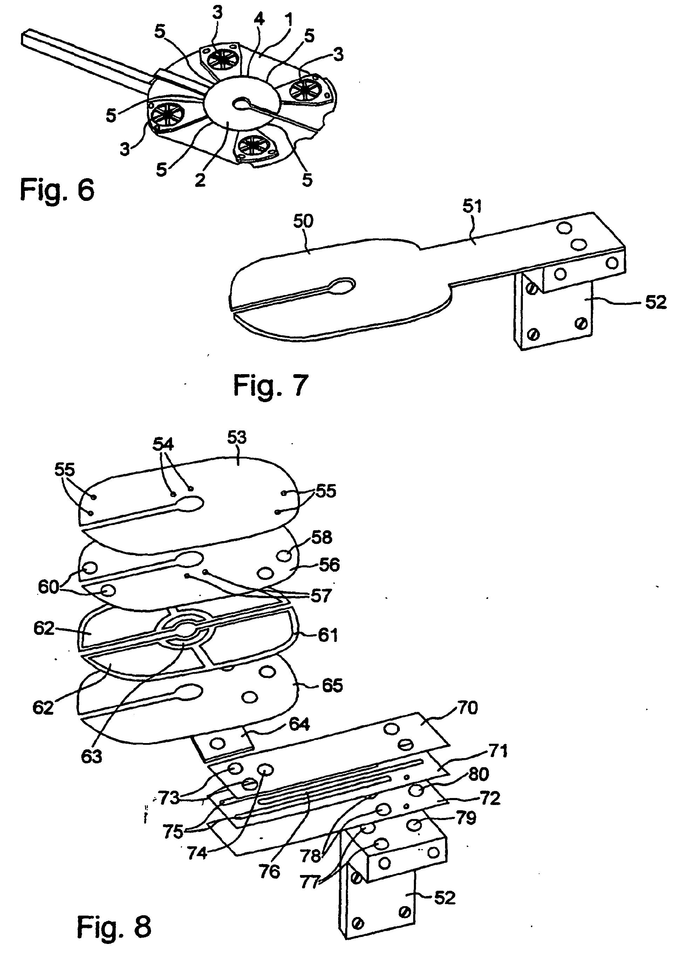

Die anhand der Fig. 1 bis 5 beschriebene Konstruktion des erfindungsgemäßen Greifers erlaubt es, diesen weitgehend beliebig auszugestalten. So kann der Greifer auch so, wie dies in Fig. 6 dargestellt ist, ausgeführt sein, wobei der Teil des Greifers mit der Druckgas-/Vakuumzuführung gegenüber dem eigentlichen Greifer mit Basisplatte 1 und Deckplatte 2 durch eine Kröpfung versetzt angeordnet ist; dabei kann, wie in Fig. 6 gezeigt, beispielsweise ein radialer Schlitz zur mittigen Öffnung im Greifer vorgesehen sein. Fig. 6 zeigt, dass die Grundplatte 1 nicht kreisrund sein muss, sondern abgeflachte Randbereiche und an ihrem Rand Ausnehmungen aufweisen kann.

Dies gilt auch für die nachstehend anhand der Fig. 7 und 8 sowie 9 bis 12 beschriebenen Ausführungsformen eines erfindungsgemäßen Greifers.

So kann der erfindungsgemäße Greifer unter Beibehalten seines Bauprinzips derart konstruiert werden, dass er an den jeweiligen Einsatzzweck angepasst ist.

Der in den Fig. 7 bis 12 gezeigte Greifer ist insgesamt löffelartig ausgebildet und besitzt den eigentlichen Greiferteil 50, der über einen Verbindungsteil 51 mit einer Halterung 52 verbunden ist. Wie später noch beschrieben werden wird, dient die Halterung 52 zur Versorgung des Greifers mit Druckgas bzw. Unterdruck, wobei in dem Verbindungsteil 51 Kanäle für das Weiterleiten von Druckgas und Unterdruck in dem Greiferteil 50 angeordnet sind.

Über die Halterung 52 kann der Greifer der Ausführungsform von Fig. 7 mit einem Manipulator bzw. Roboter verbunden werden, damit der Greifer die gewünschten Bewegungen beispielsweise beim Entnehmen von Wafern aus Horden und Ablegen derselben in ein Quarzboot ausführen kann.

Der Greiferteil 50 besteht in Fig. 8 von oben nach unten gesehen aus einer flexiblen Folie 53, in der auf einem um die Mitte des Greiferteils 50 angeordneten Kreis verteilt angeordnet Austrittsöffnungen 54 für das Druckgas zum Erzeugen einer einen Wafer gegen den Greifer hin ziehenden Kraft nach dem Bernoulli-Prinzip vorgesehen sind. Im Bereich des Randes der Folie 53 sind Öffnungen 55 vorgesehen, über die der an den Greifer angelegte Unterdruck zum Halten eines Wafers wirksam wird.

Unterhalb der flexiblen Rolle 53 ist eine Deckplatte 56 angeordnet. In der Deckplatte 56 sind mit den Austrittsöffnungen bzw. Löchern 54 fluchtende, schräg zu einer senkrecht zum Greifer stehenden Achse ausgerichtete Bohrungen 57, aus denen von unten her zugeführtes Druckgas ausströmt, vorgesehen. Die Bohrungen 57 sind so wie die Löcher 54 in der Folie 53 wenigstens im Bereich ihrer oberen Enden bevorzugt auf einem zur Achse des Greiferteils 50 konzentrischen Kreis angeordnet.

In der Deckplatte 56 sind weitere Aussparungen 58, die im Ausführungsbeispiel kreisrund sind, vorgesehen. In diesen Aussparungen 58 sind Vakuumköpfe 60 angeordnet. Unterhalb der Deckplatte 56 ist eine Zwischenplatte 61 vorgesehen. In der Zwischenplatte 61 sind Aussparungen 62 vorgesehen, die zusammen mit der Deckplatte 56 und einer unter der Zwischenplatte 61 angeordneten Basisplatte 65 Vakuumkammern bilden.

In der Zwischenplatte 61 ist wenigstens eine weitere Aussparung 63 vorgesehen, in deren Bereich die unteren Enden der Bohrungen 57 in der Deckplatte 56 münden. Die Aussparung 63 bildet zusammen mit der Basisplatte 65 und der Deckplatte 56 eine mit Druckgas beaufschlagte Kammer.

Der wie beschreiben aus der flexiblen Folie 53 der Deckplatte 56 der Zwischenplatte 61 und der Basisplatte 65 gebildete Greiferteil 50 liegt über eine Distanzplatte 64 auf der Oberseite des Verbindungsteils 51 auf und ist mit diesem verbunden.

Der Verbindungsteil 51 besteht aus einer oberen Abdeckplatte 70, einer Zwischenlage 71 und einer Grundplatte 72. In dem dem Greiferteil 50 zugekehrten Ende der Abdeckplatte 70 sind Löcher 73 vorgesehen, die mit den Aussparungen 62 in der Zwischenplatte 61 kommunizieren. Weiter ist an dem dem Greiferteil 50 zugekehrten Ende der Abdeckplatte 70 ein Loch 74 vorgesehen, das mit der Aussparung 63 in der Zwischenplatte 61 kommuniziert.

In der Zwischenlage 71 sind längslaufende Schlitze 75 und 76 vorgesehen. Die Schlitze 75, 76 in der Zwischenlage 71 bilden zusammen mit der Abdeckplatte 70 und der Grundplatte 72 im Verbindungsteil 51 Kanäle zum Zuführen von Unterdruck, der über Kanäle 77 in der Halterung 52 und Löcher 78 in der Grundplatte 72 wirksam wird.

Der Schlitz 76 in der Zwischenlage 71 bildet zusammen mit der Abdeckplatte 70 und der Grundplatte 72 einen Kanal für das Zuführen von Druckgas, wobei der Kanal für Druckgas über einen Kanal 79 in der Halterung 52 mit einer Druckgasquelle verbunden ist. Aus dem Kanal 79 in der Halterung 52 zugeführtes Druckgas tritt über ein Loch 80 in der Grundplatte 72 in den vom Schlitz 76 gebildeten Kanal ein.

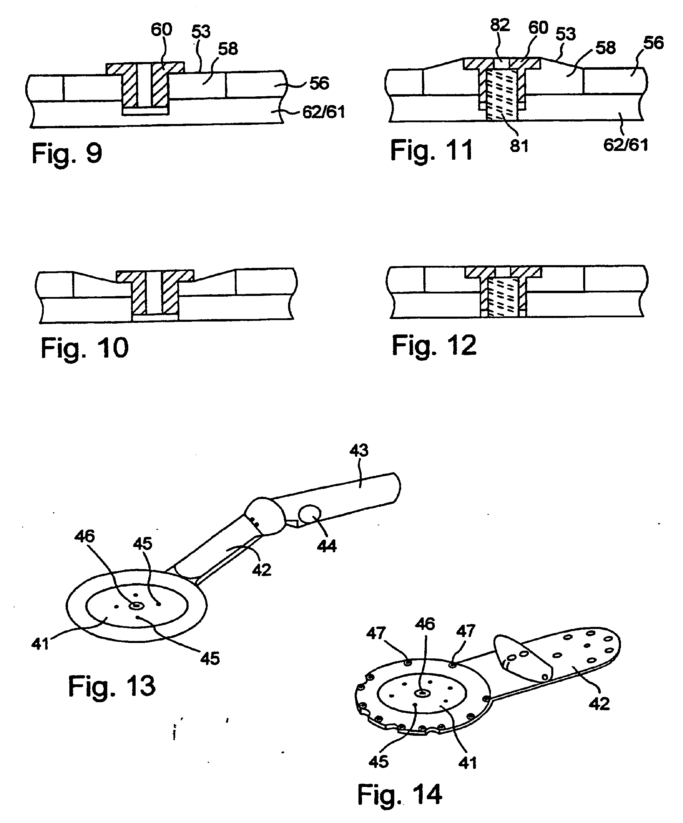

Für die Ausbildung der Vakuumköpfe 60 gibt es zwei bevorzugte Ausführungsmöglichkeiten, nämlich die in den Fig. 9 und 10 einerseits und die in den Fig. 11 und 12 andererseits gezeigte Form.

Bei der in Fig. 9 gezeigten Ausführungsform sitzen die Vakuumköpfe 60 in entsprechenden Löchern der flexiblen Folie 53 und liegen mit einem Randflansch von oben her auf der flexiblen Folie 53 auf, sodass sie in den Aussparungen bzw. Löchern 58 der Deckplatte 56 in einer zur Ebene des Greiferteils 50 normalen Richtung beweglich sind. Werden die Vakuumköpfe 60 bei der in Fig. 9 gezeigten Ausführungsform über die Vakuumkammer, die von den Aussparungen 62 in der Zwischenplatte 61 sowie der Deckplatte 56 und der (in Fig. 9 nicht gezeigten) Basisplatte 65 begrenzt werden, mit Unterdruck beaufschlagt, dann bewegen sie sich auch wegen des in der Vakuumkammer entstehenden Unterdrucks unter elastischem Verformen der flexiblen Folie 53 in die in Fig. 1 gezeigte Lage, in der ihre obere Endfläche mit der einem Wafer zugekehrten Seite des Greiferteils 50 fluchtet.

Bei der in Fig. 11 und 12 gezeigten Ausführungsform sind die Vakuumköpfe 60 unterhalb der flexiblen Folie 53 angeordnet und nehmen, wenn sie nicht mit Unterdruck beaufschlagt sind, die in Fig. 11 gezeigte Lage ein, in die sie von einer Feder 81 gedrückt werden. Bei dieser Ausführungsform wird das an die Vakuumköpfe 60 angelegte Vakuum über Löcher 82 in der flexiblen Folie 53 zum Halten eines Wafers am Greiferteil 50 wirksam. Werden die Vakuumköpfe 60 und die Vakuumkammern mit Unterdruck beaufschlagt, dann nehmen sie unter Zusammendrücken der Feder 81 die in Fig. 12 gezeigte Lage ein, in die Folie 53 völlig eben ist, also die oberen Endflächen der Vakuumköpfe 60 über die einem Wafer zugekehrte Fläche des Greiferteils 50 nicht vorstehen.

Der Überstand der Vakuumköpfe 60 in den in Fig. 9 bzw. 11 gezeigten Lagen kann klein gewählt werden und beispielsweise wenige Zehntelmillimeter betragen.

Bei der in den Fig. 7 bis 12 gezeigten Ausführungsform ist der Auslass des Druckgases zum Erzeugen einer einen Wafer gegen den Greifer ziehenden Kraft nach dem Bernoulli-Prinzip durch mehrere Einzeldüsen gebildet, die durch schräge (spitzer Winkel) und dünne (Durchmesser einige Zehntelmillimeter) Bohrungen in der Deckplatte 56 verwirklicht werden. Die Bohrungen 57 sind so angeordnet, dass das ihnen zugeführte Druckgas gleichmäßig auf der Greiferoberfläche ausströmt. Dies wird im gezeigten Ausführungsbeispiel durch die im Bereich der unteren Enden der Bohrungen 57 im Wesentlichen kreisringförmig ausgebildete Aussparung 63 in der Zwischenplatte 61 erreicht. Wie oben beschrieben ist, wird Druckgas den Bohrungen 57 im gezeigten Ausführungsbeispiel durch ein Kanalsystem im Verbindungsteil 51 zugeführt.

Bei der in den Fig. 7 bis 12 gezeigten Ausführungsform sind zum Halten eines Wafers am Greifer mit Unterdruck mehrere Unterdruckeinrichtungen vorgesehen. Diese Unterdruckeinrichtungen bestehen im gezeigten Ausführungsbeispiel aus den Vakuumköpfen 60, der flexiblen Folie 53 und den von den Aussparungen bzw. Löchern 58 in der Deckplatte 56 und den Aussparungen 62 in der Zwischenplatte 61 gebildeten Unterdruckkammern. Bei dem in den Fig. 9 und 10 gezeigten Ausführungsbeispiel sind die Vakuumköpfe 60 in Löcher in der flexiblen Folie 53 eingearbeitet, sodass die Vakuumköpfe 60 unmittelbar an dem zu haltenden Gegenstand, beispielsweise einem Wafer, anliegen. Bei der in den Fig. 11 und 12 gezeigten Ausführungsform ist die flexible Folie 53 über den oberen Enden der Vakuumköpfe angeordnet und im Bereich jedes Vakuumkopfes 60 mit einer Öffnung für das Wirksamwerden von Unterdruck versehen. In diesem Fall (grundsätzlich ist dies auch bei der Ausführungsform nach Fig. 9 und 10 möglich) belastet die Schraubenfeder 81 den Vakuumkopf 60 und somit die flexible Folie 53 derart, dass der Vakuumkopf 60, wenn er nicht mit Unterdruck beaufschlagt wird, etwas über die Greiferoberfläche vorsteht.

Das Funktionsprinzip sowohl der in den Fig. 1 bis 5 gezeigten Ausführungsform als auch der in den Fig. 7 bis 12 gezeigten Ausführungsform wird nachstehend erläutert:

Durch das Ausströmen von Druckgas auf die Greiferoberfläche wird nach dem Bernoulli-Prinzip (parallele Geschwindigkeitskomponente zum Greifer und Wafer) eine Kraft erzeugt, die den Wafer (gegebenenfalls verbogen und verspannt) zur Greiferoberfläche hin zieht und damit in Anlage an die Vakuumköpfe bringt, die sich etwas (einige Zehntelmillimeter) über der Greiferoberfläche befinden. Die senkrecht zur Ebene des Greifers beweglichen Vakuumköpfe passen sich durch eine Bewegung senkrecht zur Greiferfläche und/oder eine Kippbewegung der Oberfläche des Wafers an. Die Beweglichkeit der Vakuumköpfe ist vorteilhaft, da der Wafer, auch wenn er auf Grund der nach dem Bernoulli-Prinzip entstehenden Kraft zum Greifer hin gezogen wird, noch eine Restwelligkeit aufweisen kann. Sobald sich die Vakuumköpfe an die Wafer-Oberfläche angelegt haben, kann das Vakuum wirken und der Wafer wird durch die Vakuumköpfe seitlich stabilisiert. Zusätzlich entsteht in den die Vakuumköpfe umgebenden Unterdruckkammern ein Unterdruck, der die Vakuumköpfe - diese standen zunächst über die Greiferoberfläche vor - senkrecht zur Greiferoberfläche zurückzieht, bis sich ein stabiler Zustand zwischen ausströmendem Druckgas und Vakuum bildet. Nach dem Abschalten des Druckgases bewegen sich die Vakuumköpfe weiter senkrecht zum Greifer, bis die Vakuumköpfe in einer Ebene mit der Greiferoberfläche liegen und somit den Wafer plan bzw. eben auf dem Greifer halten.

Fig. 13 zeigt ein weiteres Ausführungsbeispiel eines Greifers mit einer Bernoulli-Düsenplatte 41, die über eine Trägerplatte 42 mit einem Griff 43 verbunden ist. Im Griff 43 ist ein Druckventil 44 vorgesehen, mit dem der Druck von Luft eingestellt werden kann, die über den Griff 43, die Trägerplatte 42 und die Bernoulli-Düsenplatte 41 zu Düsen 45 geliefert ist, um über diese ausgegeben zu werden. Außerdem befindet sich in der Mitte der Düsenplatte 41 noch eine Saugbohrung 46, über die Luft zur Düsenplatte 41 und von dort über die Trägerplatte 42 und den Griff 43 angesaugt wird. Der Saugluftdruck und der Druck der über die Düsen 45 ausgeströmten Luft sind getrennt steuerbar, wozu entsprechende Mittel am bzw. im Griff 43 vorgesehen werden können.

Wird der in Fig. 13 gezeigte Greifer um 180° gedreht, sodass die Düsen 45 und die Saugbohrung 46 in der Zeichnung nach unten weisen, so kann ohne weiteres eine Halbleiterscheibe bzw. ein Wafer aufgenommen werden: die aus den Düsen 45 ausströmende Luft sorgt nach dem Bernoulli-Prinzip für einen hydrodynamischen Unterdruck, sodass allein auf Grund dieses Unterdrucks die Halbleiterscheibe an der Düsenplatte 41 "haftet". Da aber allein infolge des Unterdrucks die Halbleiterscheibe unter der Düsenplatte 41 "schwimmt", das heißt sich lateral instabil verhält, ist zusätzlich die Saugbohrung 46 vorgesehen. Durch den über die Saugbohrung 46 erzeugten Saugdruck wird die Halbleiterscheibe auf die Düsenplatte 41 "zentriert", sodass ein stabiler und zuverlässiger Transport bzw. eine sichere Handhabung der Halbleiterscheibe gewährleistet ist.

Die Bauhöhe der Düsenplatte 41 beträgt 2 bis 3 mm, sodass sie ohne weiteres zwischen zwei übereinander in einer Horde liegenden Halbleiterscheiben eingefahren werden kann, um beispielsweise die untere Scheibe dieser beiden Halbleiterscheiben aufzunehmen.

Solange sich eine Halbleiterscheibe auf der Düsenplatte 41 befindet und bei dieser über die Düsen 45 Luft ausströmt, ist die Halbleiterscheibe in hohem Ausmaß eingeebnet. Das heißt, konkave und konvexe Krümmungen werden durch den hydrodynamischen Unterdruck ausgeglichen.

Fig. 14 zeigt ein weiteres Ausführungsbeispiel der Vorrichtung, das sich von dem Ausführungsbeispiel der Fig. 1 im Wesentlichen dadurch unterscheidet, dass zusätzlich zu der Saugbohrung 46 in der Mitte der Düsenplatte 41 auch in der diese umgebenden Trägerplatte 42 weitere Saugbohrungen 47 vorgesehen sind. Mit einem derartigen Greiferarm, wie er in Fig. 14 gezeigt ist, ist ein Bestücken von Quarzbooten mit Halbleiterscheiben in besonders vorteilhafter Weise möglich.

## Patentansprüche

1. Greifer zum Handhaben dünner, scheibenförmiger Gegenstände, insbesondere Wafer der Halbleitertechnik, umfassend
- wenigstens eine Düse (45) für Druckgas, durch das nach dem Bernoulli-Prinzip durch Saugdruck zwischen dem Gegenstand und dem Greifer eine den Gegenstand zum Greifer hin ziehende Kraft erzeugt wird und
- wenigstens einen Vakuumkopf (3, 60), der mit einem dynamischen Unterdruck beaufschlagt ist,
**dadurch gekennzeichnet, dass**
- der wenigstens eine Vakuumkopf (3, 60) senkrecht zu der dem Gegenstand zugekehrten Fläche des Greifers beweglich ist, und
- der hydrodynamische Unterdruck und der Saugdruck getrennt steuerbar sind.

2. Greifer nach Anspruch 1,
**dadurch gekennzeichnet, dass**
die wenigstens eine Düse für Druckgas radial innerhalb der Vakuumköpfe (3, 60) angeordnet ist.

3. Greifer nach Anspruch 1 oder 2,
**dadurch gekennzeichnet, dass**
die wenigstens eine Düse für Druckgas im Bereich eines nach innen versetzten Randes (4) einer Deckplatte (2) des Greifers vorgesehen ist.

4. Greifer nach einem der Ansprüche 1 bis 3,
**dadurch gekennzeichnet, dass**
die Vakuumköpfe (3, 60) im Bereich des Außenrandes des Greifers angeordnet sind.

5. Greifer nach einem der Ansprüche 1 bis 4,
**dadurch gekennzeichnet, dass**
die Vakuumköpfe (3) in elastisch verformbaren Halteteilen (6) befestigt sind.

6. Greifer nach Anspruch 5,
**dadurch gekennzeichnet, dass**
die Halteteile (6) für die Vakuumköpfe (3) zwischen einer Basisplatte (1) und einer Deckplatte (2) des Greifers angeordnet sind.

7. Greifer nach Anspruch 6,
**dadurch gekennzeichnet, dass**
in der Basisplatte (1) und in der Deckplatte (2) konzentrische Öffnungen (17, 8) vorgesehen sind, innerhalb welcher die Vakuumköpfe (3) angeordnet sind.

8. Greifer nach einem der Ansprüche 5 bis 7,
**dadurch gekennzeichnet, dass**
die Vakuumköpfe (3) in einem Haltering (9) der Halteteile (6) eingesetzt sind, der über Speichen (10) mit dem Halteteil (6) verbunden ist.

9. Greifer nach einem der Ansprüche 1 bis 8,
**dadurch gekennzeichnet, dass**
zwischen der Basisplatte (1) und der Deckplatte (2) ein Bauteil (20) als Druckgas-/Vakuumzuführung angeordnet ist.

10. Greifer nach Anspruch 9,
**dadurch gekennzeichnet, dass**
an einem annähernd scheibenförmigen Teil (24) des Bauteils (20) für die Druckgas-/Vakuumzuführung Kanäle (11) in den Halteteilen (6), durch welche die Vakuumköpfe (3) mit Unterdruck beaufschlagt werden, angeschlossen sind.

11. Greifer nach einem der Ansprüche 1 bis 10,
**dadurch gekennzeichnet, dass**
die Vakuumköpfe (3) an ihrer dem scheibenförmigen Gegenstand zugekehrten Fläche mit einer tellerartigen Ausformung (13) mit nach oben abstehenden Vorsprüngen (14, 15) ausgebildet sind.

12. Greifer nach Anspruch 11,
**dadurch gekennzeichnet, dass**
am Teller (13) eine ringförmige Rippe (14) vorgesehen ist.

13. Greifer nach Anspruch 11 oder 12,
**dadurch gekennzeichnet, dass**
an der Oberseite des Tellers (13) im Kreis herum angeordnete Vorsprünge (15) vorgesehen sind.

14. Greifer nach Anspruch 13,
**dadurch gekennzeichnet, dass**
die Vorsprünge (15) segmentförmig sind.

15. Greifer nach einem der Ansprüche 10 bis 14,
**dadurch gekennzeichnet, dass**
der Bauteil (20) zur Druckgas-/Vakuumzuführung zwischen Basisplatte (1) und Deckplatte (2) angeordnet ist.

16. Greifer nach einem der Ansprüche 10 bis 15,
**dadurch gekennzeichnet, dass**
an der der Deckplatte (2) zugekehrten Seite des scheibenförmigen Teils (24) an der Deckplatte (2) von unten her anliegende Rippen (25) vorgesehen sind, wobei zwischen benachbarten Rippen Freiräume (26) vorgesehen sind, die zusammen mit der Deckplatte (2) die düsenartige Ausströmöffnung (5) für Druckgas bilden.

17. Greifer nach einem der Ansprüche 10 bis 16,
**dadurch gekennzeichnet, dass**
an der der Basisplatte (1) zugekehrten Seite des scheibenförmigen Teils (24) zwischen zum Rand hin offenen Ausschnitten (29), in welche die Halteteile (6) eingreifen, nach unten vorspringende Rippen (28) vorgesehen sind, die an der Basisplatte (1) anliegen.

18. Greifer nach einem der Ansprüche 10 bis 17,
**dadurch gekennzeichnet, dass**
an der der Deckplatte (2) zugekehrten Seite des scheibenförmigen Teils (24) eine gegebenenfalls gestufte Ringrippe (27) vorgesehen ist, die im Bereich eines mittigen Loches in der Deckplatte (2) an dieser anliegt.

19. Greifer nach einem der Ansprüche 10 bis 18,
**dadurch gekennzeichnet, dass**
an der der Basisplatte (1) zugekehrten Seite des scheibenförmigen Teils (24) eine Ringrippe vorgesehen ist, die dichtend im Bereich einer mittigen Öffnung in der Basisplatte (1) an dieser anliegt.

20. Greifer nach einem der Ansprüche 6 bis 19,
**dadurch gekennzeichnet, dass**
in der Deckplatte (2) den Halteteilen (6) und der Basisplatte (1) in deren radial außen liegenden Bereichen Löcher (31) für die genannten Bauteile zusammenhaltende Verbindungsmittel vorgesehen sind.

21. Greifer nach einem der Ansprüche 1 bis 4,
**dadurch gekennzeichnet, dass**
die Vakuumköpfe (60) im nicht mit Unterdruck beaufschlagten Zustand über die dem zu haltenden Gegenstand zugekehrte Fläche des Greifers überstehen.

22. Greifer nach Anspruch 21,
**dadurch gekennzeichnet, dass**
die Vakuumköpfe (60) durch Bewegen senkrecht zur Ebene des Greifers in eine Stellung verstellbar sind, in der ihre dem zu haltenden Gegenstand zugekehrten Endflächen mit der dem Gegenstand zugekehrten Fläche des Greifers fluchten.

23. Greifer nach Anspruch 21 oder 22,
**dadurch gekennzeichnet, dass**
ein zum Halten eines scheibenförmigen Gegenstandes dienender Greiferteil (50) des Greifers wenigstens aus einer Deckplatte (56), einer Zwischenplatte (61) und einer Basisplatte (65) besteht.

24. Greifer nach Anspruch 23,
**dadurch gekennzeichnet, dass**
die Vakuumköpfe (60) in Aussparungen (58) in der Deckplatte (56) angeordnet sind.

25. Greifer nach einem der Ansprüche 21 bis 25,
**dadurch gekennzeichnet, dass**
auf der dem zu haltenden Gegenstand zugekehrten Seite der Deckplatte (56) eine flexible Deckfolie (53) angeordnet ist.

26. Greifer nach Anspruch 25,
**dadurch gekennzeichnet, dass**
die dem zu haltenden Gegenstand zugekehrten Enden der Vakuumköpfe (60) oberhalb der flexiblen Folie (53) angeordnet sind.

27. Greifer nach Anspruch 25,
**dadurch gekennzeichnet, dass**
die dem zu haltenden Gegenstand zugekehrten Enden der Vakuumköpfe (60) unterhalb der flexiblen Folie (53) angeordnet sind.

28. Greifer nach einem der Ansprüche 21 bis 27,
**dadurch gekennzeichnet, dass**
in einem den Greiferteil (50) mit einer Halterung (52) verbindenden Verbindungsteil (51) wenigstens ein Kanal (76) für das Zuführen von Druckgas und wenigstens ein Kanal (75) für das Anlegen von Unterdruck vorgesehen ist.

29. Greifer nach Anspruch 28,
**dadurch gekennzeichnet, dass**
der wenigstens eine Kanal (76) für das Zuführen von Druckgas durch einen Schlitz in einer Zwischenlage (71), die zwischen einer Abdeckplatte (70) und einer Grundplatte (72) des Verbindungsteils (51) angeordnet ist, gebildet ist, wobei die Abdeckplatte (70) und die Grundplatte (72) an der Zwischenlage (71) anliegen.

30. Greifer nach Anspruch 28,
**dadurch gekennzeichnet, dass**
der wenigstens eine Kanal (75) zum Anlegen von Unterdruck durch einen Langschlitz in einer Zwischenlage (71), die zwischen einer Abdeckplatte (70) und einer Grundplatte (72) des Verbindungsteils (51) angeordnet ist, wobei die Abdeckplatte (70) und die Grundplatte (72) an der Zwischenlage (71) anliegen, gebildet ist.

31. Greifer nach einem der Ansprüche 23 bis 30,
**dadurch gekennzeichnet, dass**
in der Zwischenplatte (61) wenigstens eine Aussparung (62) vorgesehen ist, die über wenigstens ein Loch (73) in der Deckplatte (70) des Verbindungsteils (51) mit dem vom Schlitz (75) gebildeten Kanal im Verbindungsteil (51) kommuniziert.

32. Greifer nach einem der Ansprüche 23 bis 31,
**dadurch gekennzeichnet, dass**
in der Zwischenplatte (61) wenigstens eine Aussparung (63) vorgesehen ist, die über wenigstens ein Loch (74) in der Deckplatte (70) des Verbindungsteils (51) mit dem vom Schlitz (76) gebildeten Kanal für Druckgas in Verbindung steht.

33. Greifer nach einem der Ansprüche 23 bis 32,
**dadurch gekennzeichnet, dass**
in der Deckplatte (56) wenigstens eine Düse (57) für den Austritt von Druckgas vorgesehen ist.

34. Greifer nach einem der Ansprüche 23 bis 33,
**dadurch gekennzeichnet, dass**
mehrere Bohrungen (57) als Düsen für den Austritt von Druckgas vorgesehen sind.

35. Greifer nach Anspruch 33 oder 34,
**dadurch gekennzeichnet, dass**
die Bohrungen (57) für Druckgas mit einer senkrecht zum Greiferteil (50) stehenden Achse spitze Winkel einschließen.

36. Greifer nach Anspruch 34 oder 35,
**dadurch gekennzeichnet, dass**
in der Deckfolie (53) Löcher (54) vorgesehen sind, die mit den oberen Enden der Bohrungen (57) fluchten.

37. Greifer nach einem der Ansprüche 25 bis 36,
**dadurch gekennzeichnet, dass**
in der Deckfolie (53) Löcher (55) vorgesehen sind, die mit Löchern in den Vakuumköpfen (60), über die Unterdruck wirksam wird, fluchten.

38. Greifer nach einem der Ansprüche 21 bis 37,
**dadurch gekennzeichnet, dass**
den Vakuumköpfen (60) Federn (81) zugeordnet sind, welche diese in ihre über die dem zu haltenden Gegenstand zugekehrte Fläche des Greifers vorstehende Lage belasten.

## Claims

1. Gripper for handling thin, disc-shaped objects, in particular wafers in the field of semiconductor technology, comprising
- at least one nozzle (45) for compressed gas, by means of which a force is produced according to the Bernoulli principle, pulling the object towards the gripper by means of suction pressure between the object and the gripper and
- at least one vacuum head (3, 60) which is impinged upon by a dynamic negative pressure,
**characterized in that**
- the at least one vacuum head (3, 60) may be moved perpendicularly to the surface of the gripper to be turned towards the object, and
- the hydrodynamic negative pressure and the suction pressure may be controlled separately.

2. Gripper according to Claim 1, **characterized in that** the at least one nozzle for compressed gas is arranged radially inside the vacuum heads (3, 60).

3. Gripper according to Claim 1 or 2, **characterized in that** the at least one nozzle is provided for compressed gas in the region of an inwardly offset edge (4) of a cover plate (2) of the gripper.

4. Gripper according to one of Claims 1 to 3, **characterized in that** the vacuum heads (3, 60) are arranged in the region of the outer edge of the gripper.

5. Gripper according to one of Claims 1 to 4, **characterized in that** the vacuum heads (3) are fastened in elastically deformable retaining parts (6).

6. Gripper according to Claim 5, **characterized in that** the retaining parts (6) for the vacuum heads (3) are arranged between a base plate (1) and a cover plate (2) of the gripper.

7. Gripper according to Claim 6, **characterized in that** in the base plate (1) and in the cover plate (2) concentric openings (17, 8) are provided, inside which the vacuum heads (3) are arranged.

8. Gripper according to one of Claims 5 to 7, **characterized in that** the vacuum heads (3) are inserted in a retaining ring (9) of the retaining parts (6) which is connected via spokes (10) to the retaining part (6).

9. Gripper according to one of Claims 1 to 8, **characterized in that** a component (20) is arranged between the base plate (1) and the cover plate (2) as a compressed gas/vacuum supply.

10. Gripper according to Claim. 9, **characterized in that** channels (11) in the retaining parts (6), through which the vacuum heads (3) are impinged upon by negative pressure, are attached to an approximately disc-shaped part (24) of the component (20) for the compressed gas/vacuum supply.

11. Gripper according to one of Claims 1 to 10, **characterized in that** the vacuum heads (3) are configured on their surface facing the disc-shaped object, with a plate-shaped recess (13) with upwardly protruding projections (14, 15).

12. Gripper according to Claim 11, **characterized in that** an annular rib (14) is provided on the plate (13).

13. Gripper according to Claim 11 or 12, **characterized in that** projections (15) are provided, arranged circumferentially on the upper face of the plate (13).

14. Gripper according to Claim 13, **characterized in that** the projections (15) are segment-shaped.

15. Gripper according to one of Claims 10 to 14, **characterized in that** the component (20) for the compressed gas/vacuum supply is arranged between the base plate (1) and the cover plate (2).

16. Gripper according to one of Claims 10 to 15, **characterized in that** on the face of the disc-shaped part (24) facing the cover plate (2), ribs (25) are provided, bearing against the cover plate (2) from below, free spaces (26) being provided between adjacent ribs, which free spaces together with the cover plate (2) form the nozzle-like outlet aperture (5) for compressed gas.

17. Gripper according to one of Claims 10 to 16, **characterized in that** downwardly projecting ribs (28) which bear against the base plate (1) are provided on the face of the disc-shaped part (24) facing the base plate (1) between cut-outs (29) which are open towards the edge and in which the retaining parts (6) engage.

18. Gripper according to one of Claims 10 to 17, **characterized in that** a stepped annular rib (27) is possibly provided on the face of the disc-shaped part (24) facing the cover plate (2) and which bears thereagainst in the region of a central hole in the cover plate (2).

19. Gripper according to one of Claims 10 to 18, **characterized in that** an annular rib is provided on the face of the disc-shaped part (24) facing the base plate (1) and which, in the region of a central opening in the base plate (1), sealingly bears thereagainst.

20. Gripper according to one of Claims 6 to 19, **characterized in that** in the cover plate (2), the retaining parts (6) and the base plate (1) holes (31) are provided in the outer radial regions thereof, for connecting means holding the aforementioned components together.

21. Gripper according to one of Claims 1 to 4, **characterized in that** in the state where they are not impinged upon by negative pressure, the vacuum heads (60) project over the surface of the gripper facing the object to be retained.

22. Gripper according to Claim 21, **characterized in that** the vacuum heads (60) may be adjusted by being moved perpendicular to the plane of the gripper into a position in which their end surfaces facing the object to be retained are aligned with the surface of the gripper facing the object.

23. Gripper according to Claim 21 or 22, **characterized in that** a gripper part (50) of the gripper serving to retain a disc-shaped object consists at least of a cover plate (56), an intermediate plate (61) and a base plate (65).

24. Gripper according to Claim 23, **characterized in that** the vacuum heads (60) are arranged in recesses (58) in the cover plate (56).

25. Gripper according to one of Claims 21 to 25, **characterized in that** on the face of the cover plate (56) facing the object to be retained, a flexible cover film (53) is arranged.

26. Gripper according to Claim 25, **characterized in that** the ends of the vacuum heads (60) facing the object to be retained are arranged above the flexible film (53).

27. Gripper according to Claim 25, **characterized in that** the ends of the vacuum heads (60) facing the object to be retained are arranged below the flexible film (53).

28. Gripper according to one of Claims 21 to 27, **characterized in that** in a connecting part (51) connecting the gripper part (50) to a support (52), at least one channel (76) is provided for supplying compressed gas and at least one channel (75) is provided for applying negative pressure.

29. Gripper according to Claim 28, **characterized in that** the at least one channel (76) is formed for the supply of compressed gas through a slot in an intermediate layer (71), which is arranged between a cover plate (70) and a base plate (72) of the connecting part (51), the cover plate (70) and the base plate (72) bearing against the intermediate layer (71).

30. Gripper according to Claim 28, **characterized in that** the at least one channel (75) is formed for applying negative pressure through a longitudinal slot in an intermediate layer (71), which is arranged between a cover plate (70) and a base plate (72) of the connecting part (51), the cover plate (70) and the base plate (72) bearing against the intermediate layer (71).

31. Gripper according to one of Claims 23 to 30, **characterized in that** in the intermediate plate (61) at least one recess (62) is provided which communicates via at least one hole (73) in the cover plate (70) of the connecting part (51) with the channel in the connecting part (51) formed by the slot (75).

32. Gripper according to one of Claims 23 to 31, **characterized in that** in the intermediate plate (61) at least one recess (63) is provided, which is connected via at least one hole (74) in the cover plate (70) of the connecting part (51) with the channel for compressed gas formed by the slot (76).

33. Gripper according to one of Claims 23 to 32, **characterized in that** at least one nozzle (57) is provided in the cover plate (56) for the outflow of compressed gas.

34. Gripper according to one of Claims 23 to 33, **characterized in that** a plurality of bores (57) are provided as nozzles for the outflow of compressed gas.

35. Gripper according to Claim 33 or 34, **characterized in that** the bores (57) for compressed gas enclose an acute angle with an axis located perpendicular to the gripper part (50).

36. Gripper according to Claim 34 or 35, **characterized in that** holes (54) are provided in the cover film (53) which are aligned with the upper ends of the bores (57).

37. Gripper according to one of Claims 25 to 36, **characterized in that** holes (55) are provided in the cover film (53) which are aligned with holes in the vacuum heads (60) via which the negative pressure is effective.

38. Gripper according to one of Claims 21 to 37, **characterized in that** springs (81) are associated with the vacuum heads (60) which load said vacuum heads in their position projecting over the surface of the gripper facing the object to be retained.

## Revendications

1. Dispositif de préhension pour manipuler de minces objets en forme de disque, notamment des tranches de la technique des semi-conducteurs , comprenant
- au moins une buse (45) pour du gaz comprimé par laquelle il est produit, suivant le principe de Bernoulli, par pression d'aspiration entre l'objet et le dispositif de préhension une force attirant l'objet vers le dispositif de préhension ; et
- au moins une ventouse (3, 60) qui est alimentée par une dépression dynamique,
**caractérisé en ce que**
- la au moins une ventouse (3, 60) est mobile perpendiculairement à la surface du dispositif de préhension, qui est tournée vers l'objet ; et
- la dépression hydrodynamique et la pression d'aspiration peuvent être commandées séparément.

2. Dispositif suivant la revendication 1,
**caractérisé en ce que** la au moins une buse pour du gaz comprimé est disposée radialement à l'intérieur des ventouses (3, 60).

3. Dispositif suivant la revendication 1 ou 2,
**caractérisé en ce que** la au moins une buse pour du gaz comprimé est prévue dans la région d'un bord (4) décalé vers l'intérieur d'une plaque (2) de couverture du dispositif de préhension.

4. Dispositif suivant l'une des revendications 1 à 3,
**caractérisé en ce que** les ventouses (3, 60) sont disposées dans la région du bord extérieur du dispositif de préhension.

5. Dispositif suivant l'une des revendications 1 à 4,
**caractérisé en ce que** les ventouses (3) sont fixées dans des parties (6) fixes de maintien déformables élastiquement.

6. Dispositif suivant la revendication 5,
**caractérisé en ce que** les parties (6) de maintien des ventouses (3) sont disposées entre une plaque (1) de base et une plaque (2) de couverture du dispositif de préhension.

7. Dispositif suivant la revendication 6,
**caractérisé en ce qu'**il est prévu dans la plaque (1) de base et dans la plaque (2) de couverture des ouvertures (17, 8) concentriques à l'intérieur desquelles sont disposées les ventouses (3).

8. Dispositif suivant l'une des revendications 5 à 7,
**caractérisé en ce que** les ventouses (3) sont insérées dans un anneau (9) de maintien des parties (6) de maintien qui est relié à la partie (6) de maintien par des rayons (10).

9. Dispositif suivant l'une des revendications 1 à 8,
**caractérisé en ce qu'**il est disposé entre la plaque (1) de base et la plaque (2) de couverture un élément (20) servant à apporter le gaz comprimé/le vide.

10. Dispositif suivant la revendication 9,
**caractérisé en ce qu'**il est raccordé à une partie (24) de l'élément (20) sensiblement en forme de disque pour l'apport de gaz comprimé/vide des canaux (11) dans les parties (6) de maintien, par lesquels les ventouses (3) peuvent être alimentées par une dépression.

11. Dispositif suivant l'une des revendications 1 à 10,
**caractérisé en ce que** les ventouses (3) sont constituées sur la surface tournée vers l'objet en forme de disque en ayant une excroissance (13) en forme d'assiette ayant des saillies (14, 15) vers le haut.

12. Dispositif suivant la revendication 11,
**caractérisé en ce qu'**il est prévu sur l'assiette (13) une nervure (14) annulaire.

13. Dispositif suivant la revendication 11 ou 12,
**caractérisé en ce qu'**il est prévu sur la face supérieure de l'assiette (13) des saillies (15) disposées en cercle tout autour.

14. Dispositif suivant la revendication 13,
**caractérisé en ce que** les saillies (15) sont en forme de segment.

15. Dispositif suivant l'une des revendications 10 à 14,
**caractérisé en ce que** l'élément (20) d'apport de gaz comprimé/vide est disposé entre la plaque (1) de base et la plaque (2) de couverture.

16. Dispositif suivant l'une des revendications 10 à 15,
**caractérisé en ce qu'**il est prévu, sur la face de la partie (24) en forme de disque tournée vers la plaque (2) de couverture, des nervures (25) s'appliquant à partir du bas sur la plaque (2) de couverture, des espaces libres (26) qui forment ensemble avec la plaque (2) de couverture une ouverture (5) de sortie en forme de buse pour du gaz comprimé étant prévus entre des nervures voisines.

17. Dispositif suivant l'une des revendications 10 à 16,
**caractérisé en ce qu'**il est prévu, sur la face de la partie (24) en forme de disque, tournée vers la plaque (1) de base entre des entailles (29) qui sont ouvertes vers le bord et dans lesquelles pénètrent les parties (6) de maintien, des nervures (28) en saillie vers le bas et s'appliquant à la plaque (1) de base.

18. Dispositif suivant l'une des revendications 10 à 17,
**caractérisé en ce qu'**il est prévu, sur la face de la partie (24) en forme de disque, tournée vers la plaque (2) de couverture, une nervure (27) annulaire, le cas échéant étagée, qui s'applique dans la partie d'un trou central de la plaque (2) de couverture à celle-ci.

19. Dispositif suivant l'une des revendications 10 à 18,
**caractérisé en ce qu'**il est prévu, sur la face de la partie (24) en forme de disque, tournée vers la plaque (1) de base, une nervure annulaire qui s'applique de manière étanche dans la région d'une ouverture centrale de la plaque (1) de base à celle-ci.

20. Dispositif suivant l'une des revendications 6 à 19,
**caractérisé en ce qu'**il est prévu dans la plaque (2) de couverture, dans les parties (6) de maintien et dans la plaque (1) de base dans leur région s'étendant radialement vers l'extérieur, des trous (31) pour des moyens de liaison maintenant ensemble lesdits éléments.

21. Dispositif suivant l'une des revendications 1 à 4,
**caractérisé en ce que** les ventouses (60) dépassent, dans l'état où elles ne sont pas alimentées par une dépression, des surfaces du dispositif de préhension tournées vers l'objet à maintenir.

22. Dispositif suivant la revendication 21,
**caractérisé en ce que** les ventouses (60) sont réglables par déplacement perpendiculairement au plan du dispositif de préhension pour venir en une position dans laquelle leur surface d'extrémité tournée vers l'objet à maintenir est alignée avec la surface du dispositif de préhension tournée vers l'objet.

23. Dispositif suivant la revendication 21 ou 22,
**caractérisé en ce qu'**une partie (50) du dispositif de préhension servant à maintenir un objet en forme de disque est constituée au moins d'une plaque (56) de couverture, d'une plaque (61) intermédiaire et d'une plaque (65) de base.

24. Dispositif suivant la revendication 23,
**caractérisé en ce que** les ventouses (60) sont disposées dans des évidements (58) de la plaque (56) de couverture.

25. Dispositif suivant l'une des revendications 21 à 25,
**caractérisé en ce qu'**une feuille (53) souple de couverture est disposée du côté de la plaque (56) de couverture tournée vers l'objet à maintenir.

26. Dispositif suivant la revendication 25,
**caractérisé en ce que** les extrémités des ventouses (60) tournées vers l'objet à maintenir sont disposées au-dessus de la feuille (53) souple.

27. Dispositif suivant la revendication 25,
**caractérisé en ce que** les extrémités des ventouses (60) tournées vers l'objet à maintenir sont disposées en dessous de la feuille (53) souple.

28. Dispositif suivant l'une des revendications 21 à 27,
**caractérisé en ce qu'**il est prévu dans une partie (51) de liaison reliant la partie (50) du dispositif de préhension à une fixation (52) au moins un canal (76) pour l'apport de gaz comprimé et au moins un canal (75) pour l'application d'une dépression.

29. Dispositif suivant la revendication 28,
**caractérisé en ce que** le au moins un canal (76) pour l'apport de gaz comprimé est formé par une fente dans une couche (71) intermédiaire interposée entre une plaque (70) de recouvrement et une plaque (72) de fond de la partie (51) de liaison, la plaque (70) de recouvrement et la plaque (72) de fond s'appliquant à la couche (71) intermédiaire.

30. Dispositif suivant la revendication 28,
**caractérisé en ce que** le au moins un canal (75) d'application d'une dépression est formé par une fente oblongue dans une couche (71) intermédiaire qui est disposée entre une plaque (70) de recouvrement et une plaque (72) de fond de la partie (51) de liaison, la plaque (70) de recouvrement et la plaque (72) de fond s'appliquant à la couche (71) intermédiaire.

31. Dispositif suivant l'une des revendications 23 à 30,
**caractérisé en ce qu'**il est prévu dans la plaque (61) intermédiaire au moins un évidement (62) qui communique par au moins un trou (73) de la plaque (70) de recouvrement de la partie (51) de liaison avec le canal formé par la fente (75) dans la partie (51) de liaison.

32. Dispositif suivant l'une des revendications 23 à 31,
**caractérisé en ce qu'**il est prévu dans la plaque (61) intermédiaire au moins un évidement (63) qui est en communication par au moins un trou (74) de la plaque (70) de recouvrement de la partie (51) de liaison avec le canal pour du gaz comprimé qui est formé par la fente (76).

33. Dispositif suivant l'une des revendications 23 à 32,
**caractérisé en ce qu'**il est prévu dans la plaque (56) de couverture au moins une buse (57) de sortie du gaz comprimé.

34. Dispositif suivant l'une des revendications 23 à 33,
**caractérisé par** plusieurs orifices (57) prévus en tant que buses pour la sortie du gaz comprimé.

35. Dispositif suivant la revendication 33 ou 34,
**caractérisé en ce que** les orifices (57) pour du gaz comprimé font un angle aigu avec un axe perpendiculaire à la partie (50) du dispositif de préhension.

36. Dispositif suivant la revendication 34 ou 35,
**caractérisé en ce qu'**il est prévu dans la feuille (53) de recouvrement des trous (54) qui sont alignés avec les extrémités supérieures des trous (57).

37. Dispositif suivant l'une des revendications 25 à 36,
**caractérisé en ce qu'**il est prévu dans la feuille (53) de recouvrement des trous (55) qui sont alignés avec des trous dans les ventouses (60) par lesquels la dépression est efficace.

38. Dispositif suivant l'une des revendications 21 à 37,
**caractérisé en ce qu'**il est associé aux ventouses (60) des ressorts (81) qui tendent à les mettre dans leur position en saillie de la surface du dispositif de préhension tournée vers la pièce à maintenir.
